(19) Europäisches Patentamt

European Patent Office

Office européen des brevets

(11) EP 0 684 649 B1

(12) EUROPEAN PATENT SPECIFICATION

(45) Date of publication and mention of the grant of the patent:
30.05.2001 Bulletin 2001/22

(51) Int Cl.⁷: H01L 27/108

(21) Application number: 95112708.3

(22) Date of filing: 06.07.1990

(54) **Dynamic random access memory**

Dynamischer Speicher mit wahlfreiem Zugriff

Mémoire dynamique à accès aléatoire

(84) Designated Contracting States:
DE FR GB

(43) Date of publication of application:
29.11.1995 Bulletin 1995/48

(62) Document number(s) of the earlier application(s) in accordance with Art. 76 EPC:
90112927.0 / 0 464 251

(73) Proprietor: FUJITSU LIMITED
Kawasaki-shi, Kanagawa 211 (JP)

(72) Inventor: Ema, Taiji
Kawasaki-shi, Kanagawa, 213 (JP)

(74) Representative: Seeger, Wolfgang, Dipl.-Phys.
Georg-Hager-Strasse 40
81369 München (DE)

(56) References cited:
EP-A- 0 399 531          EP-A- 0 428 247

• PATENT ABSTRACTS OF JAPAN vol. 13 no. 459 (E-832) ,17 October 1989 & JP-A-01 179449 (HITACHI LTD) 17 July 1989,
• PATENT ABSTRACTS OF JAPAN vol. 13 no. 366 (E-806) [3714] ,15 August 1989 & JP-A-01 123463 (HITACHI LTD) 16 May 1989,
• IBM TECHNICAL DISCLOSURE BULLETIN, vol. 30, no. 3, August 1987 NEW YORK US, pages 1314-1315, 'Folded Bitline Configuration'
• PATENT ABSTRACTS OF JAPAN vol. 13 no. 594 (E-867) [3942] ,27 December 1989 & JP-A-01 248556 (NEC CORP) 4 October 1989,

**Description**

BACKGROUND OF THE INVENTION

The present invention generally relates to a dynamic random access memory, and more particularly to a dynamic random access memory having an improved layout. Further, the present invention is concerned with a method of arranging a memory cell pattern of the dynamic random access memory.

Recently, the layout of structural elements of a dynamic random access memory (hereinafter simply referred to as a DRAM) has been designed by using a computer. In order to reduce the amount of data to be processed, the layout is designed by using straight lines extending in two orthogonal directions and straight lines extending at an angle of 45° with respect to each of the orthogonal directions. However, advanced computers have an ability to process an extremely large amount of data at high speeds and thus make it possible to design the layout by using oblique lines which extend at angles other than 45° with respect to the aforementioned orthogonal directions.

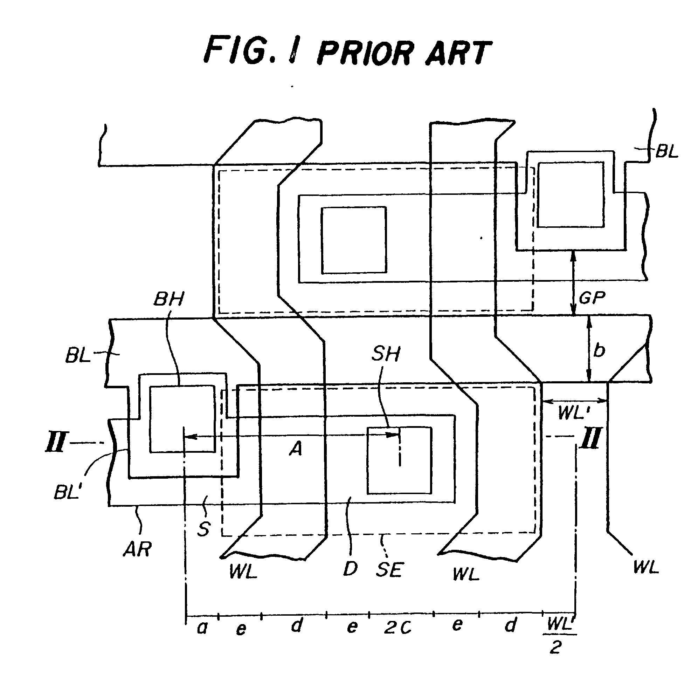

Referring to FIG.1, there is illustrated a layout of a DRAM of a stacked capacitor type. In FIG.1, AR indicates an active (diffusion) region including a drain region and a source region, a word line and S indicates a source area. D indicates a drain area. WL indicates a word line and WL' denotes the distance between the adjacent word lines WL. BL indicates a bit line and BL' indicates an extension portion of the bit line BL. BH indicates a bit line contact hole and SE indicates a storage electrode. SH indicates a storage electrode contact hole. GP is the space between the extension portion BL' of the bit line BL and the adjacent bit line BL.

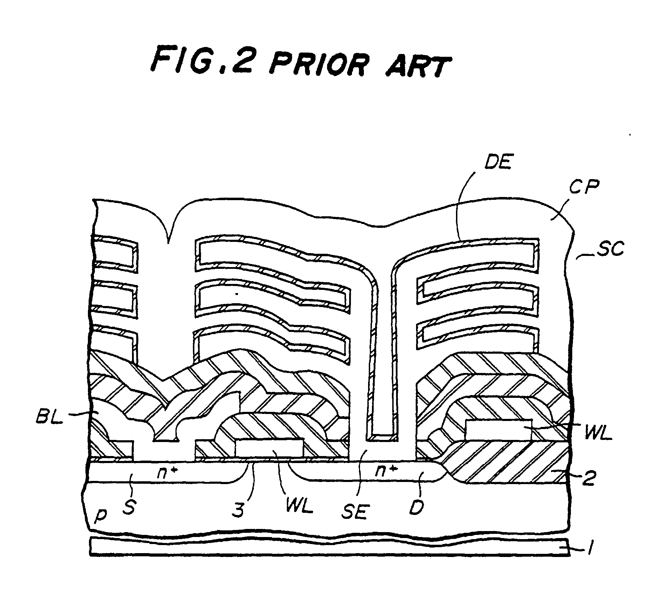

FIG.2 is a sectional view taken along line II-II shown in FIG.1. A P-type silicon semiconductor substrate 1 has a source region S and drain region D of a transfer transistor, both of which are active regions (impurity diffused regions) buried in the Si substrate 1. A field insulating layer 2 and a gate insulating layer 3 are formed on the Si substrate 1. CP indicates an opposed electrode (cell plate) of a storage capacitor. The bit line BL is formed at a layer level lower than that of the opposed electrode CP. The word line WL, the bit line BL, the storage electrode SE and the opposed electrode CP are stacked in this order. A stacked capacitor is composed of the storage electrode SE, a dielectric film DE and the cell plate CP. This arrangement would become popular as the size of memory cells is further reduced.

In the arrangement shown in FIGS.1 and 2, each bit line contact hole BH used for electrically coupling the bit line BL and the source region S of the transfer transistor must be positioned so that it keeps away from the word line WL. The storage electrode contact hole SH used for electrically coupling the storage electrode SE and the drain region D of the transfer transistor must be positioned so that it keeps away from both the word line WL and the bit line BL.

Each bit line BL must be provided with the extension portion BL' which is formed so that it surrounds the contact hole BH. The presence of the extension portion BL' increases the surface area of the bit line BL so that a parasitic capacitance is increased. In addition, the arrangement shown in FIGS.1 and 2 causes short circuiting in the vicinity of the bit line extension portion BL', since the distance GP between the bit line extension portion BL' and the adjacent bit line BL is smaller than the distance between the adjacent bit lines BL.

Length DM of each memory cell measured in the direction in which each bit line BL extends is described as follows.

$$DM = a + e + d + e + 2c + e + d + 1/2WL'$$

$$= A + c + e + d + 1/2WL'$$

where

| | |
|---|---|
| a: | half the width of the bit line contact hole BH |
| e: | alignment margin of each of the contact holes |
| d: | the width of the word line WL |
| c: | half the width of the storage electrode contact hole SH |
| WL': | the distance between the adjacent word lines W1 |

It can be seen from FIG.1 that A = a + e + d + e + c = a + c + d + 2e. The bit line contact hole BL and the storage electrode contact hole SH are arranged approximately in a line so that the length DM of each memory cell is great.

Patent Abstracts of Japan, vol. 13, no. 594, 27.12.89 & JP-A-1 248 556 and Patent Abstracts of Japan, vol 14, no. 273, 13.6.90 & JP-A-2 86164 each describe a memory device having a bent portion in the word line between a storage capacitor contact and a corresponding bit line contact.

Patent Abstracts of Japan, vol. 13, no. 459, 17.10.89 & JP-A-1 179 449 discloses that the active area has an inclination equal to 45° with respect to the bit line in order to most finely arrange the active areas and that the active areas with which the bit lines make contact are needed to extend in parallel with the bit lines.

EP-A 0 399 531 and EP-A-0 428 247, cited pursuant to Art. 54(3) EPC, each show a memory device having bent word line portions and obliquely arranged active regions.

SUMMARY OF THE INVENTION

It is general object of the present invention to provide a DRAM having an improved layout in which the aforementioned disadvantages are eliminated.

A more specific object of the present invention is to provide a DRAM having an improved layout which has no bit line extension portion for forming a bit line contact hole and which is directed to preventing the occurence of short circuiting between the adjacent bit lines.

The above-mentioned objects of the present invention are achieved by a dynamic random access memory as defined in claim 1.

Further embodiments of the invention are set out in the dependent claims.

Another object of the present invention is to provide a method of arranging a memory cell pattern of the above-mentioned dynamic random access memory.

This object of the present invention is achieved by a method according to attached claims 23 and 25.

BRIEF DESCRIPTION OF THE DRAWINGS

Other objects, features and advantages of the present invention will become apparent from the following detailed description when read in conjunction with the accompanying drawings, in which:

FIG.1 is a diagram illustrating a conventional layout of a DRAM of a stacked capacitor type;

FIG.2 is a cross sectional view taken along line II-II shown in FIG.1;

FIG.3 is a diagram illustrating a principle of the present invention;

FIG.4 is a diagram illustrating a pattern according to a preferred embodiment of the present invention;

FIGS.5A and 5B are diagrams illustrating the influence of a bird's beak;

FIG.6 is a diagram of a pattern according to the embodiment of the present invention in which four memory cells are illustrated;

FIGS.7A, 7B and 7C are diagrams illustrating how the present invention was made; and

FIG.8 is a block diagram of a folded bit line type DRAM.

DESCRIPTION OF THE PREFERRED
EMBODIMENTS

The present invention is based on the following considerations.

First, in order to eliminate the aforemetioned extension portion BL' which projects from the bit line BL and which surrounds the bit line contact hole BH, it is the best way to arrange the bit line contact hole BL so that the center thereof is positioned on the center line of the bit line BL.

Second, it is advantageous to arrange the storage electrode contact hole SH so that the center thereof is positioned at an equal distance from the adjacent bit lines BL and at an equal distance from the adjacent word lines WL.

Third, an imaginary line which connects the bit line contact hole BH and the corresponding storage electrode contact hole SH crosses the bit line BL at an angle with respect to the direction in which the bit line BL extends, that is, the center line thereof. Active regions such as source and drain regions are arranged on the basis of the imaginary line. In addition, the shape of each word line WL is determined, taking into consideration the pattern of the active regions.

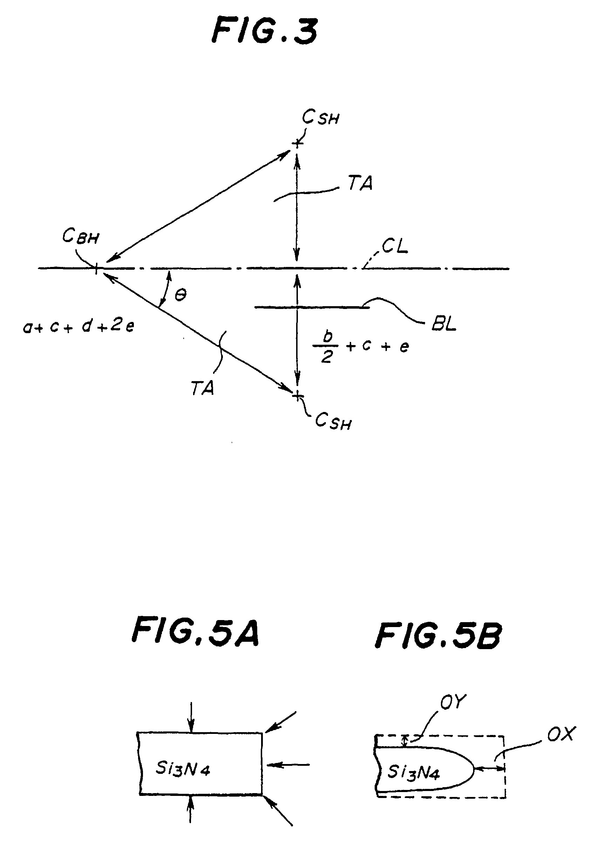

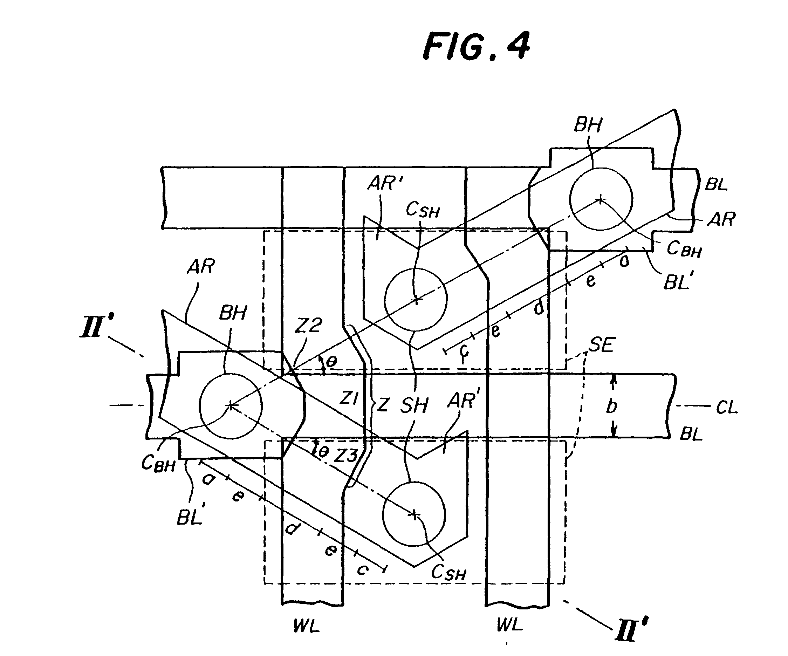

Referring to FIG.3, there is illustrated a principle of the present invention based on the above-mentioned first to third considerations. In FIG.3, those parts which have the same names of structural elements as those shown in FIG.1 are given the same reference characters. CL indicates a center line of the bit line BL, and $C_{BH}$ indicates the center of the bit line contact hole BH. $C_{SH}$ indicates the center of the storage electrode contact hole SH, and θ indicates an angle formed between the center line CL and an imaginary line which connects the center $C_{BH}$ and $C_{SH}$.

A distance A between the center $C_{BH}$ of the bit line contact hole BH and the center $C_{SH}$ of the storage electrode contact hole SH, that is, the length A of the imaginary line therebetween is described as follows.

$$A = a + c + d + 2e$$

The distance between the center line CL of the bit line BL and the center $C_{SH}$ of the storage electrode contact hole BH is written as follows.

$$1/2b + c + e$$

It can be seen from FIG.3 that two right-angled isosceles triangles TA are formed. Thus, the able e is written as follows.

$$\theta = \sin^{-1}[(1/2b + e + c) / (a + c + d + 2e)] \qquad (1)$$

The memory cell pattern is determined so that formula (1) is satisfied. It is possible to determine the memory cell pattern so that the angle θ is nearly equal to the right term of formula (1).

Referring to FIG.4, there is illustrated a layout of a DRAM according to a preferred embodiment of the present invention. In FIG.4, those parts which have the same names as those shown in the previous figures are given the same reference characters. In FIG.4, a letter b denotes the width of the bit line BL, and AR' indicates a bent portion of the active region AR. Z is a bent portion of the word line WL. Z1, Z2 and Z3 indicate areas of the word line WL which form the bent portion Z of the word line WL.

The center $C_{BH}$ of the bit line contact hole BH is positioned on the center line CL of the bit line BL. Although the bit line BL shown in FIG.4 has an extension portion for forming the bit line contact hole BH, it is very smaller than that shown in FIG.1. Thus, the distance between the extension portion of the bit line BL and the adjacent bit line BL is increased so that the occurrence of short circuiting therebetween can be reduced.

The length A of the imaginary line which connects the center $C_{BH}$ of the bit line contact hole BH and the center $C_{SH}$ of the storage electrode contact hole SH is equal to a + c + d +2e, as described previously. The angle θ of the line with respect to the center line CL of the bit line BL is selected, as defined by formula (1). The minimum distance between the center $C_{SH}$ of the storage electrode contact hole SH and the center line CL of the bit line BL is equal to 1/2b + c + e.

The active area AR extends along the imaginary line which connects the center $C_{BH}$ of the bit line contact hole BH and the center $C_{SH}$ of the storage electrode contact hole SH. That is, the active area AR is arranged obliquely with respect to the bit line BL. The active area AR has a bent portion AR' which is symmetrically bent or curved with respect to a line which passes through the center $C_{SH}$ of the storage electrode contact hole SH and which is perpendicular to the center line CL of the bit line BL.

The bent portion AR' of the active area AR reduces the influence of bird's beaks. Referring to FIG.5A, there is illustrated a silicon nitride ($Si_3N_4$) film used for selectively oxidizing the Si substrate to thereby produce an oxide layer (field insulating layer) for element-to-element isolation. Oxygen is supplied with a short end of the $Si_3N_4$ film along various directions, as shown by arrows in FIG.5A. Thus, the bird's beak occurs at the short end of the $Si_3N_4$ film and an Si substrate surface portion in the vicinity of the short end is oxidized, as indicated by arrow OX shown in FIG.5B. Although an Si substrate surface portion in the vicinity of a long end of the $Si_3N_4$ is also oxidized, as indicated by arrow OY shown in FIG. 5B, it is smaller than that indicated by the arrow OX. The bent portion AR' of the active region AR is provided for taking into account the occurrence of the above-mentioned bird's beak. It should be noted that it is impossible to provide a bent portion which straight extends from the active area AR because of the presence of the bit line contact hole BH.

The direction in which each word line WL extends is perpendicular to the direction in which each bit line BL extends. Each word line WL has the bent portion Z, which is composed of the areas Z1, Z2 and Z3. The area Z1 is orthogonal to the center line CL of the bit line CL. The areas Z2 and Z3 are located on both sides of the area Z1. Each of the areas Z2 and Z3 is orthogonal to the corresponding line which connects the center $C_{BH}$ of the bit line contact hole BH and the center $C_{SH}$ of the storage electrode contact hole SH. The areas Z2 and Z3 are arranged symmetically with the area Z1.

According to the layout shown in FIG.4, the length L of each memory cell measured in the direction in which the bit line BL extends is as follows.

$$ L = 2 \times \sqrt{(a + c + d + 2e)^2 - (1/2b + c + e)^2} $$

It can be seen from the above formula that the length L of memory cell is not based on the distance WL' between the adjacent word lines. As a result, it is possible to increase the distance WL' and reduce the possibility of the occurrence of short circuiting.

When the minimum distance between the adjacent lines is 0.5 [μm], the parameters are selected as follows.

    a = c = 0.3 [μm]
    b = d = 0.5 [μm]
    e = 0.4 [μm]
    WL' = 0.5 [μm]

In this case, the length of each memory cell in the direction in which the bit line BL extends is 3.29 [μm]. On the other hand, the length of each memory in the same direction according to the aforementioned prior arrangement shown in FIG.1 is 3.35 [μm] when the distance between the adjacent word lines is set equal to 0.5 [μm].

The distance between the adjacent word lines according to the arrangement shown in FIG.4 is 0.8 [μm]. On the other hand, the distance between the adjacent word lines according to the prior arrangement shown in FIG.1 is 0.5 [μm].

The distance between the adjacent bit lines according to the arrangement shown in FIG.4 is 1.0 [μm]. On the other hand, the distance between the adjacent bit lines according to the prior arrangement shown in FIG.4 is 0.5 [μm].

The area of each memory cell according to the arrangement shown in FIG.4 is slightly less than that shown in FIG.1. The distance between the adjacent bit lines BL and the word lines WL in the memory cells is 1.6 - 2 times that of the prior arrangement.

The cross section taken along line II'-II' is almost the same as that shown in FIG.2. The stacked capacitor is not limited to the structure shown in FIG.2. For example, it is possible to form the stacked capacitor so that the storage electrode SE has a single fin. It is also possible to form the stacked capacitor so that the single fin or the lowermost fin from among a plurality of fins is separated from the insulating layer and the opposed electrode is also provided between the single fin or the lowermost fin and the insulating layer.

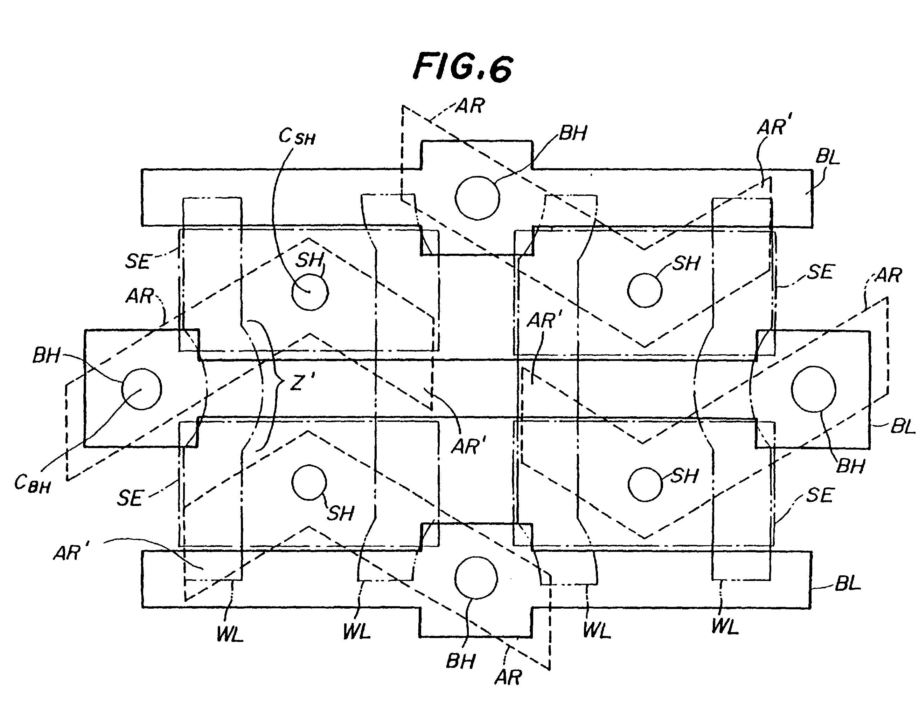

FIG.6 is a diagram showing the layout of four memory cells. In FIG.6, those parts which are the same as those in the previous figures are given the same reference numerals. It will be noted that the bent portion AR' of each active area AR shown in FIG.6 is greater than that shown in FIG.4. That is, the bent portion AR' of each active area AR is located under the corresponding word line WL. It will also be noted that a curved part Z' of each word line WL which crosses the bit line BL is curved without having the areas Z1, Z2 and Z3. Even in the arrangement shown in FIG.6, the imaginary line connecting the center $C_{BH}$ of the bit line contact hole BH and the center $C_{SH}$ of the storage electrode contact hole $C_{SH}$ is perpendicular to the curved part Z' of the word line WL. All of memory cell patterns can be formed by repeatedly arranging the layout shown in FIG.6.

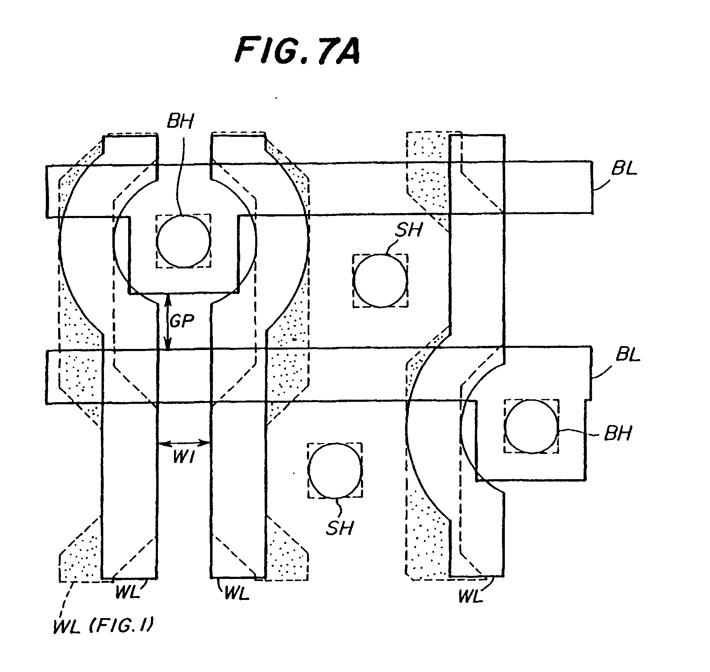

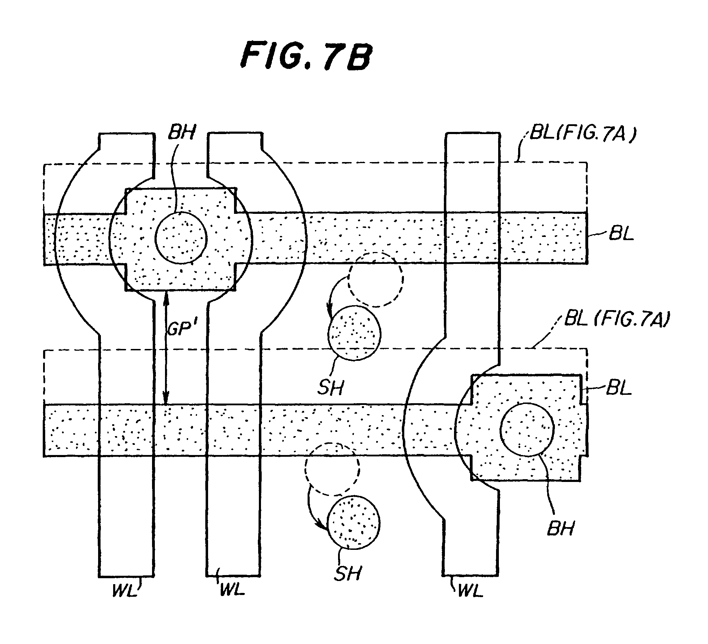

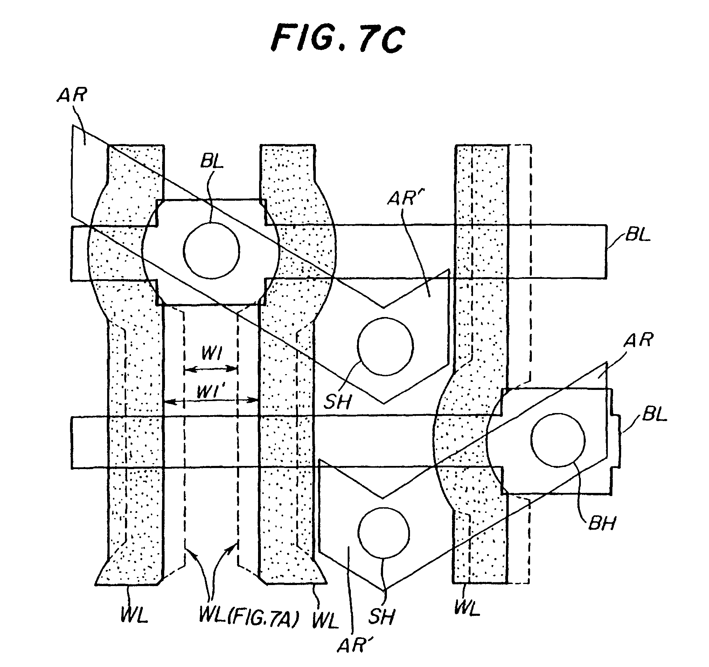

FIGS.7A, 7B and 7C are diagrams illustrating how the present invention was made. In FIGS.7A through 7C, those parts which have the same names as those described previously are given the same reference letters. Referring to FIG.7A, the dotted line illustrates the pattern of the conventional word line WL as shown in FIG.1. A contact hole formed in a fine pattern is approximately of a circle shape due to the intensity distribution of light. Thus, it is possible to consider each contact hole as a circle on the pattern layout drawing. The word lines are required to be separated from the bit line contact holes BH at a predetermined distance. Thus, it is possible to partially shape each word line WL into a circular arc in order to keep away from the bit line contact holes BH at the predetermined distance. As a result, dotted areas between the adjacent word lines WL become available. Thus, as shown in FIG.7B, it becomes possible to obliquely shift the positions of the storage electrode contact holes SH. Due to the positional change in the storage electrode contact holes SH, it becomes possible to shift the positions of the bit lines BL so that the bit line contact holes BH are located at the center thereof, as shown in FIG.7B. Thereby, it is possible to substantially eliminate the bit line extension portions as shown in FIG.1 or FIG.7A so that each bit line BL is substantially straight. In addition, it is possible to increase the distance between the adjacent bit lines BL from GP (FIG.7A) to GP' (FIG.7B). Further, due to this positional change of the storage electrode contact holes SH, it becomes possible to shift the positions of the word lines WL, as illustrated in FIG.7C. As a result, it becomes possible to increase the distance between the opposite edges of the adjacent word lines WL from W1 to W1', as shown in FIG.7C. On the other hand, the distance between the other opposite ends of the adjacent word lines WL is decreased, as shown in FIG.7C. It is possible to arbitrarily determine the distances W1' and W2' on the basis of various requirements. Moreover,

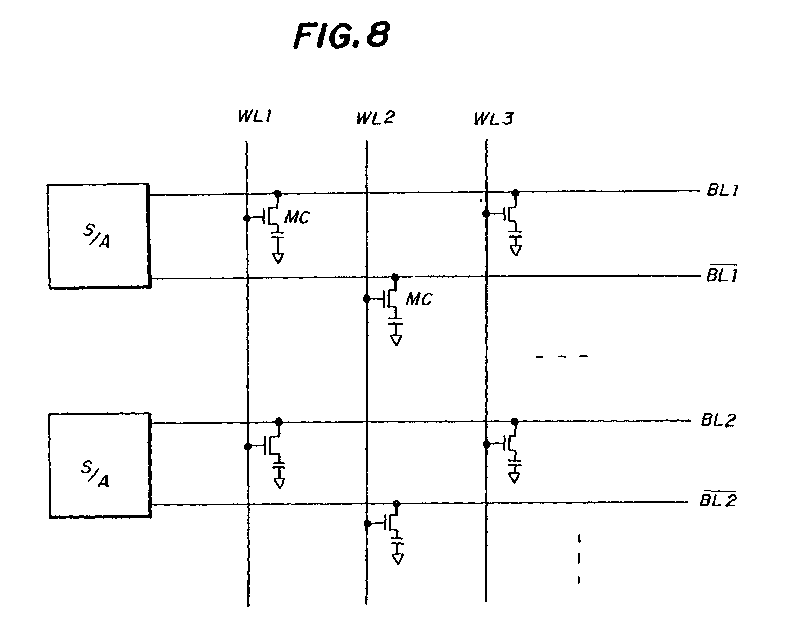

FIG.8 is a block diagram of a folded bit line type DRAM. A plurality of pairs of bit lines, such as BL1 and $\overline{BL1}$, extend from corresponding sense amplifiers S/A. A plurality of word lines extend so as to cross the bit lines, as described previously. A memory cell MC is coupled between one of the bit lines and one of the word lines. The pattern arrangements according to the present invention are suitable for the folded bit line type DRAM as shown in FIG.8. However, the arrangements are also applicable to an open bit line type DRAM.

**Claims**

1. A dynamic random access memory comprising:

   a semiconductor substrate (1) having an active region (AR) including first and second diffusion regions (D, S) of a transfer transistor,
   an insulating layer (2, 3) formed on said semiconductor substrate and having first and second contact holes (SH, BH),
   a stacked capacitor (SC) having a storage electrode (SE) which is electrically connected to said first diffusion region through said first contact hole formed in said insulating layer and an opposed electrode (CP),
   a word line (WL) electrically isolated from said semiconductor substrate, and
   a bit line (BL) electrically isolated from said semiconductor substrate and electrically connected to said second diffusion region through said second contact hole formed in said insulating layer,
   a conductive layer forming the bit lines (BL) is located at a level lower than that of a conductive layer forming the opposed electrode (CP),
   said second contact hole being positioned at a center of said bit line,
   said active region (AR) being obliquely arranged with respect to said bit line (BL) and said word line (WL) such that the first contact hole (SH) does not overlap the bit line (BL), and the second diffusion region being disposed so as to cross the bit line,

   characterized in that said contact holes have an approximately circular shape,

   said word line has a bent portion (Z, Z', Z1, Z2, Z3) located between said first (SH) and second (BH) contact holes, said bent portion being substantially concentric with the centre of said second contact hole (BH) and comprising a plurality of straight segments separated from said second contact hole (BH) by a distance being equal to or larger than a predetermined minimum distance, and
   in that the active region (AR) comprises a bent active portion (AR') which is bent at the centre of said first contact hole (SH) and which extends towards said bit line (BL).

2. A dynamic random access memory as claimed in claim 1, characterized in that said bent portion (Z, Z') of the word line is arranged so that said bent portion is orthogonal to an imaginary line which connects a center ($C_{SH}$) of said first contact hole (SH) and a center ($C_{BH}$) of said second contact hole (BH).

**3.** A dynamic random access memory as claimed in claim 1, wherein said active region (AR) is arranged along an imaginary line which connects a center ($C_{SH}$) of said first contact hole (SH) and a center ($C_{BH}$) of said second contact hole (BH).

**4.** A dynamic random access memory as claimed in any of claims 1 to 3, characterized in that said bent portion (Z') of the word line has an arc-shaped pattern.

**5.** A dynamic random access memory as claimed in any of claims 1 to 3, characterized in that:

said bent portion (Z) of the word line has a first area (Z1), a second area (Z2) and a third area (Z3) which are integrally formed in this order; said second area is orthogonal to said bit line; and

one of said first and second areas is orthogonal to an imaginary line which connects a center ($C_{SH}$) of said first contact hole (SH) and a center ($C_{BH}$) of said second contact hole (BH).

**6.** A dynamic random access memory as claimed in claim 5, characterized in that said first and third areas (Z1, Z3) are arranged in symmetry with each other about said second area.

**7.** A danymic random access memory as claimed in claim 1, characterized in that:

said active region (AR) comprises a straight portion integrally formed with said bent active portion (AR') thereof; and

said bent active portion of the active region is partially in symmetry with said straight portion about said center ($C_{SH}$) of the first contact hole (SH).

**8.** A dynamic random access memory as claimed in claim 1, characterized in that said bent active portion (AR') of the active region (AR) has an end which is located below said bit line (BL).

**9.** A dynamic random access memory as claimed in claim 1, characterized in that said bent active portion (AR') of the active region (AR) is obliquely arranged with respect to said bit line (BL).

**10.** A dynamic random access memory as claimed in any of claims 1 to 9, characterized in that:

an imaginary line which connects a center ($C_{SH}$) of said first contact hole (SH) and a center ($C_{BH}$) of said second contact hole (BH) is inclined at an angle θ with respect to a direction in which said bit line (BL) extends; and

said angle θ is defined substantially as follows:

$$\theta = \sin^{-1}[(1/2b + e + c) / (a + c + d + 2e)]$$

where

a:   half a width of the second contact hole,

e:   an alignment margin of each of said first and second contact holes,

d:   a width of the word line,

c:   half a width of said second contact hole, and

b:   a width of said bit line.

**11.** A dynamic random access memory as claimed in any of claims 1 to 10, characterized in that said first diffusion region is a drain region (D) and said second diffusion region is a source region (S).

**12.** A dynamic random access memory according to claim 1, comprising on said semiconductor substrate (1):

a plurality of said active regions (AR) each including first and second diffusion regions (D, S) of a respective transfer transistor,

said insulating layer (2, 3) having a plurality of first contact holes (SH) and a plurality of second contact holes (BH),

a plurality of said stacked capacitors (SC) each having a storage electrode (SE) which is electrically connected to a corresponding one of said first diffusion regions through a corresponding one of said first contact holes formed in said insulating layer, and an opposed electrode (CP),

a plurality of said word lines (WL) electrically isolated from said semiconductors substrate, and

a plurality of said bit lines (BL) electrically isolated from said semiconductor substrate, each of said bit lines being electrically connected to a corresponding one of said second diffusion regions through a corresponding one of the second contact holes formed in said insulating layer,

each of said second contact holes being positioned at a center (CL) of said bit lines,

each of said active regions (AR) being obliquely arranged with respect to said bit lines (BL) and said word lines (WL), the second diffusion region being disposed so as to cross the bit line,

wherein each of said word lines has a plurality of said bent portions (Z, Z') located between corresponding first and second contact holes each bent portion being separated from a corresponding one of said second contact holes by said predetermined distance, and each of said active regions (AR) comprises a bent active portion (AR') which is bent at a center of a corresponding one of the first contact holes (SH) and which extends toward a corresponding one of the bit lines (BL).

13. A dynamic random access memory as claimed in claim 12, characterized in that:

each of said first contact holes (SH) is located at an almost equal distance from two adjacent word lines from among said plurality of word lines (WL); each of said first contact holes is located at an almost equal distance from two adjacent bit lines from among said plurality of bit lines (BL).

14. A dynamic random access memory as claimed in claim 12 or claim 13, characterized in that each bent portion (Z, Z') of each of the word lines (WL) is arranged so that each bent portion is orthogonal to an imaginary line which connects a center ($C_{SH}$) of said corresponding one of the first contact holes (SH) and a center ($C_{BH}$) of said corresponding one of the second contact holes (BH).

15. A dynamic random access memory as claimed in claim 12, characterized in that each of said active regions (AR) is arranged along an imaginary line which connects a center ($C_{SH}$) of a corresponding one of said first contact holes (SH) and a center ($C_{BH}$) of a corresponding one of said second contact holes (BH).

16. A dynamic random access memory as claimed in any of claims 12 to 15, characterized in that each bent portion of each of the word lines (WL) has an arc-shaped pattern (Z').

17. A dynamic random access memory as claimed in any of claims 12 to 15, characterized in that each of said active regions (AR) comprises a bent active portion (AR') extending toward a corresponding one of the bit lines (BL).

18. A dynamic random access memory as claimed in claim 17, characterized in that:

each of said active regions (AR) comprises a straight portion integrally formed with said bent active portion (AR') thereof; and said bent active portion of each of the active regions is partially in symmetry with said straight portion about said center ($C_{SH}$) of said corresponding one of the first contact holes (SH).

19. A dynamic random access memory as claimed in claim 17, characterized in that said bent active portion (AR') of each of said active regions (AR) has an end which is located below a corresponding one of the bit lines (BL).

20. A dynamic random access memory as claimed in claim 17, characterized in that said bent active portion (AR') of each of said active regions (AR) is obliquely arranged with respect to a corresponding one of the bit lines (BL).

21. A dynamic random access memory as claimed in any of claims 12 to 20, characterized in that:

an imaginary line which connects the center of one of said first contact holes (SH) and a center of a corresponding one of said second contact holes (BH) is inclined at an angle θ with respect to a direction in which said bit lines (BL) extend; and said angle θ is defined as follows:

$$\theta = \sin^{-1}\left[(1/2b + e + c) / (a + c + d + 2e)\right]$$

where

a: half a width of each of the second contact holes,

e: an alignment margin of each of said first and second contact holes

d: a width of each of the word lines, half a width of each of said second contact holes, and

b: a width of said bit lines.

22. A dynamic random access memory as claimed in any of claims 12 to 21, wherein said bit lines are of a folded-bit line type.

23. A method of arranging structural elements of a dynamic random access memory according to claim 1 or 12 comprising the steps of:

determining a first position ($C_{SH}$) which is separated from a center (CL) of said bit line at a first predetermined distance; determining a second position ($C_{BH}$) which is located at the center of said bit line and which is separated from said first position at a second predetermined distance; and determining a position of said word line (WL) so that said word line is located between said first and second contact holes, wherein: said first position corresponds to a center ($C_{SH}$) of said first contact hole (SH); and said second position corresponds to a center (C$_{BH}$) of said second contact hole (BH).

**24.** A method as claimed in claim 23, characterized in that:

said first predetermined distance is approximately equal to b/2 + c + e where b is a width of said bit line, c is half a width of said first contact hole, and e is an alignment margin of each of said first contact holes;

said second predetermined distance is approximately equal to a + c + d + 2e where a is half a width of said second contact hole.

**25.** A method of arranging structural elements of a dynamic random access memory according to claim 1 or 12 comprising the steps of:

determining a first position (C$_{BH}$) which is located at a center (CL) of said bit line;

determining a second position (C$_{SH}$) which is located on an imaginary line extending from said first position at a predetermined angle ($\theta$) with respect to said bit line and which is separated from the center of said bit line at a predetermined distance; and

determining a position of said word line (WL) so that said word line is positioned between said first and second contact holes, wherein:

said first position corresponds to a center (C$_{BH}$) of said second contact hole (BH); and

said second position corresponds to a center (C$_{SH}$) of said first contact hole (SH).

**26.** A method as claimed in claim 25, characterized in that:

said predetermined angle $\theta$ is defined substantially as follows:

$$\theta = \sin^{-1}[(1/2b + e + c) / (a + c + d + 2e)]$$

where

a: half a width of said second contact hole,

e: an alignment margin of each of said first and second contact holes,

d: a width of said word line,

c: half a width of said second contact hole, and

b: a width of said bit line; and

said predetermined distance is approximately equal to b/2 + c + e.

**Patentansprüche**

**1.** Dynamischer Speicher mit wahlfreiem Zugriff mit:

einem Halbleitersubstrat (1), das eine aktive Zone (AR) hat, die erste und zweite Diffusionszonen (D, S) eines Transfertransistors enthält, einer Isolierschicht (2, 3), die auf dem Halbleitersubstrat gebildet ist und erste und zweite Kontaktlöcher (SH, BH) hat, einem Stapelkondensator (SC) mit einer Speicherelektrode (SE), die durch das erste Kontaktloch, das in der Isolierschicht gebildet ist, mit der ersten Diffusionszone elektrisch verbunden ist, und einer Gegenelektrode (CP), einer Wortleitung (WL), die von dem Halbleitersubstrat elektrisch isoliert ist, und einer Bitleitung (BL), die von dem Halbleitersubstrat elektrisch isoliert ist und mit der zweiten Diffusionszone durch das zweite Kontaktloch, das in der Isolierschicht gebildet ist, elektrisch verbunden ist, wobei eine leitfähige Schicht, die die Bitleitungen (BL) bildet, auf einer Ebene angeordnet ist, die niedriger als jene einer leitfähigen Schicht ist, die die Gegenelektrode (CP) bildet, das zweite Kontaktloch in einer Mitte der Bitleitung positioniert ist, die aktive Zone (AR) bezüglich der Bitleitung (BL) und der Wortleitung (WL) schräg angeordnet ist, so daß das erste Kontaktloch (SH) die Bitleitung (BL) nicht überlappt, und die zweite Diffusionszone so angeordnet ist, um die Bitleitung zu kreuzen,

dadurch gekennzeichnet, daß

die Kontaktlöcher etwa kreisförmig sind, die Wortleitung einen gekrümmten Abschnitt (Z, Z', Z1, Z2, Z3) hat, der zwischen den ersten (SH) und zweiten (BH) Kontaktlöchern angeordnet ist, welcher gekrümmte Abschnitt zu der Mitte des zweiten Kontaktlochs (BH) im wesentlichen konzentrisch ist und eine Vielzahl von geraden Segmenten umfaßt, die von dem zweiten Kontaktloch (BH) durch einen Abstand getrennt sind, der gleich einem vorbestimmten Mindestabstand oder größer als dieser ist, und daß die aktive Zone (AR) einen gekrümmten aktiven Abschnitt (AR') umfaßt, der in der Mitte des ersten Kontaktlochs (SH) gekrümmt ist und sich hin zu der Bitleitung (BL) erstreckt.

**2.** Dynamischer Speicher mit wahlfreiem Zugriff nach Anspruch 1, dadurch gekennzeichnet, daß der gekrümmte Abschnitt (Z, Z') der Wortleitung so angeordnet ist, daß der gekrümmte Abschnitt zu einer imaginären Linie orthogonal ist, die eine Mitte (C$_{SH}$) des ersten Kontaktlochs (SH) und eine Mitte (C$_{BH}$) des zweiten Kontaktlochs (BH) verbindet.

**3.** Dynamischer Speicher mit wahlfreiem Zugriff nach Anspruch 1, bei dem die aktive Zone (AR) längs einer imaginären Linie angeordnet ist, die eine Mitte (C$_{SH}$) des ersten Kontaktlochs (SH) und eine Mitte (C$_{BH}$) des zweiten Kontaktlochs (BH) verbindet.

**4.** Dynamischer Speicher mit wahlfreiem Zugriff nach irgendeinem der Ansprüche 1 bis 3, dadurch gekennzeichnet, daß der gekrümmte Abschnitt (Z') der Wortleitung ein bogenförmiges Muster hat.

**5.** Dynamischer Speicher mit wahlfreiem Zugriff nach irgendeinem der Ansprüche 1 bis 3, dadurch gekennzeichnet, daß:

der gekrümmte Abschnitt (Z) der Wortleitung einen ersten Bereich (Z1), einen zweiten Bereich (Z2) und einen dritten Bereich (Z3) hat, die in dieser Ordnung integral gebildet sind; der zweite Bereich zu der Bitleitung orthogonal ist; und einer der ersten und zweiten Bereiche zu einer imaginären Linie orthogonal ist, die eine Mitte (C$_{SH}$) des ersten Kontaktlochs (SH) und eine Mitte (C$_{BH}$) des zweiten Kontaktlochs (BH) verbindet.

**6.** Dynamischer Speicher mit wahlfreiem Zugriff nach Anspruch 5, dadurch gekennzeichnet, daß die ersten und dritten Bereiche (Z1, Z3) bezüglich des zweiten Bereiches symmetrisch zueinander angeordnet sind.

**7.** Dynamischer Speicher mit wahlfreiem Zugriff nach Anspruch 1, dadurch gekennzeichnet, daß:

die aktive Zone (AR) einen geraden Abschnitt umfaßt, der mit ihrem gekrümmten aktiven Abschnitt (AR') integral gebildet ist; und der gekrümmte aktive Abschnitt der aktiven Zone mit dem geraden Abschnitt bezüglich der Mitte (C$_{SH}$) des ersten Kontaktlochs (SH) teilweise symmetrisch ist.

**8.** Dynamischer Speicher mit wahlfreiem Zugriff nach Anspruch 1, dadurch gekennzeichnet, daß der gekrümmte aktive Abschnitt (AR') der aktiven Zone (AR) ein Ende hat, das unter der Bitleitung (BL) angeordnet ist.

**9.** Dynamischer Speicher mit wahlfreiem Zugriff nach Anspruch 1, dadurch gekennzeichnet, daß der gekrümmte aktive Abschnitt (AR') der aktiven Zone (AR) bezüglich der Bitleitung (BL) schräg angeordnet ist.

**10.** Dynamischer Speicher mit wahlfreiem Zugriff nach irgendeinem der Ansprüche 1 bis 9, dadurch gekennzeichnet, daß:

eine imaginäre Linie, die eine Mitte (C$_{SH}$) des ersten Kontaktlochs (SH) und eine Mitte (C$_{BH}$) des zweiten Kontaktlochs (BH) verbindet, mit einem Winkel θ bezüglich einer Richtung, in der sich die Bitleitung (BL) erstreckt, geneigt ist; und der Winkel θ im wesentlichen wie folgt definiert ist:

$$\theta = \sin^{-1}[(1/2b + e + c) / (a + c + d + 2e)]$$

wobei

a: die Hälfte einer Breite des zweiten Kontaktlochs ist,
e: eine Ausrichtungstoleranz von jedem der ersten und zweiten Kontaktlöcher ist,
d: eine Breite der Wortleitung ist,
c: die Hälfte einer Breite des zweiten Kontaktlochs ist und
b: eine Breite der Bitleitung ist.

**11.** Dynamischer Speicher mit wahlfreiem Zugriff nach irgendeinem der Ansprüche 1 bis 10, dadurch gekennzeichnet, daß die erste Diffusionszone eine Drainzone (D) und die zweite Diffusionszone eine Sourcezone (S) ist.

**12.** Dynamischer Speicher mit wahlfreiem Zugriff nach Anspruch 1, der auf dem Halbleitersubstrat (1) umfaßt:

eine Vielzahl der aktiven Zonen (AR), die jeweils erste und zweite Diffusionszonen (D, S) eines jeweiligen Transfertransistors enthalten, die Isolierschicht (2, 3), die eine Vielzahl von ersten Kontaktlöchern (SH) und eine Vielzahl von zweiten Kontaktlöchern (BH) hat, eine Vielzahl der Stapelkondensatoren (SC), jeweils mit einer Speicherelektrode (SE), die mit einer entsprechenden der ersten Diffusionszonen durch ein entsprechendes der ersten Kontaktlöcher, die in der Isolierschicht gebildet sind, elektrisch verbunden ist, und einer Gegenelektrode (CP), eine Vielzahl der Wortleitungen (WL), die von dem Halbleitersubstrat elektrisch isoliert sind, und eine Vielzahl der Bitleitungen (BL), die von dem Halbleitersubstrat elektrisch isoliert sind, von welchen Bitleitungen jede mit einer entsprechenden der zweiten Diffusionszonen durch ein entsprechendes der zweiten Kontaktlöcher, die in der Isolierschicht gebildet sind, elektrisch verbunden ist,

wobei jedes der zweiten Kontaktlöcher in einer Mitte (CL) der Bitleitungen positioniert ist,

jede der aktiven Zonen (AR) bezüglich der Bitleitungen (BL) und der Wortleitungen (WL) schräg angeordnet ist und die zweite Diffusionszone so angeordnet ist, um die Bitleitung zu kreuzen,

bei dem jede der Wortleitungen eine Vielzahl der gekrümmten Abschnitte (Z, Z') hat, die zwischen entsprechenden ersten und zweiten Kontaktlöchern angeordnet sind, wobei jeder gekrümmte Abschnitt von einem entsprechenden der zweiten Kontaktlöcher durch den vorbestimmten Abstand getrennt ist, und

jede der aktiven Zonen (AR) einen gekrümmten aktiven Abschnitt (AR') umfaßt, der in einer Mitte eines entsprechenden der ersten Kontaktlöcher (SH) gekrümmt ist und sich hin zu einer entsprechenden der Bitleitungen (BL) erstreckt.

13. Dynamischer Speicher mit wahlfreiem Zugriff nach Anspruch 12, dadurch gekennzeichnet, daß:

jedes der ersten Kontaktlöcher (SH) in einem nahezu gleichen Abstand von zwei benachbarten Wortleitungen von der Vielzahl von Wortleitungen (WL) angeordnet ist;

jedes der ersten Kontaktlöcher in einem nahezu gleichen Abstand von zwei benachbarten Bitleitungen von der Vielzahl von Bitleitungen (BL) angeordnet ist.

14. Dynamischer Speicher mit wahlfreiem Zugriff nach Anspruch 12 oder Anspruch 13, dadurch gekennzeichnet, daß jeder gekrümmte Abschnitt (Z, Z') von jeder der Wortleitungen (WL) so angeordnet ist, daß jeder gekrümmte Abschnitt zu einer imaginären Linie orthogonal ist, die eine Mitte ($C_{SH}$) des entsprechenden der ersten Kontaktlöcher (SH) und eine Mitte ($C_{BH}$) des entsprechenden der zweiten Kontaktlöcher (BH) verbindet.

15. Dynamischer Speicher mit wahlfreiem Zugriff nach Anspruch 12, dadurch gekennzeichnet, daß jede der aktiven Zonen (AR) längs einer imaginären Linie angeordnet ist, die eine Mitte ($C_{SH}$) eines entsprechenden der ersten Kontaktlöcher (SH) und eine Mitte ($C_{BH}$) eines entsprechenden der zweiten Kontaktlöcher (BH) verbindet.

16. Dynamischer Speicher mit wahlfreiem Zugriff nach irgendeinem der Ansprüche 12 bis 15, dadurch gekennzeichnet, daß jeder gekrümmte Abschnitt von jeder der Wortleitungen (WL) ein bogenförmiges Muster (Z') hat.

17. Dynamischer Speicher mit wahlfreiem Zugriff nach irgendeinem der Ansprüche 12 bis 15, dadurch gekennzeichnet, daß jede der aktiven Zonen (AR) einen gekrümmten aktiven Abschnitt (AR') umfaßt, der sich hin zu einer entsprechenden der Bitleitungen (BL) erstreckt.

18. Dynamischer Speicher mit wahlfreiem Zugriff nach Anspruch 17, dadurch gekennzeichnet, daß:

jede der aktiven Zonen (AR) einen geraden Abschnitt umfaßt, der mit ihrem gekrümmten aktiven Abschnitt (AR') integral gebildet ist; und der gekrümmte aktive Abschnitt von jeder der aktiven Zonen mit dem geraden Abschnitt bezüglich der Mitte ($C_{SH}$) des entsprechenden der ersten Kontaktlöcher (SH) teilweise symmetrisch ist.

19. Dynamischer Speicher mit wahlfreiem Zugriff nach Anspruch 17, dadurch gekennzeichnet, daß der gekrümmte aktive Abschnitt (AR') von jeder der aktiven Zonen (AR) ein Ende hat, das unter einer entsprechenden der Bitleitungen (BL) angeordnet ist.

20. Dynamischer Speicher mit wahlfreiem Zugriff nach Anspruch 17, dadurch gekennzeichnet, daß der gekrümmte aktive Abschnitt (AR') von jeder der aktiven Zonen (AR) bezüglich einer entsprechenden der Bitleitungen (BL) schräg angeordnet ist.

21. Dynamischer Speicher mit wahlfreiem Zugriff nach irgendeinem der Ansprüche 12 bis 20, dadurch gekennzeichnet, daß

eine imaginäre Linie, die die Mitte von einem der ersten Kontaktlöcher (SH) und eine Mitte eines entsprechenden der zweiten Kontaktlöcher (BH) verbindet, mit einem Winkel θ bezüglich einer Richtung geneigt ist, in der sich die Bitleitungen (BL) erstrekken; und der Winkel θ wie folgt definiert ist:

$$\theta = \sin^{-1}[(1/2b + e + c) / (a + c + d + 2e)]$$

wobei

a: die Hälfte einer Breite von jedem der zweiten Kontaktlöcher ist,

e: eine Ausrichtungstoleranz von jedem der ersten und zweiten Kontaktlöcher ist,

d: eine Breite von jeder der Wortleitungen ist,

**10**

c: die Hälfte einer Breite von jedem der zweiten Kontaktlöcher ist und

b: eine Breite der Bitleitungen ist.

22. Dynamischer Speicher mit wahlfreiem Zugriff nach irgendeinem der Ansprüche 12 bis 21, bei dem die Bitleitungen ein gefalteter Bitleitungstyp sind.

23. Verfahren zum Anordnen von Strukturelementen eines dynamischen Speichers mit wahlfreiem Zugriff nach Anspruch 1 oder 12 mit den folgenden Schritten:

Bestimmen einer ersten Position ($C_{SH}$), die von einer Mitte (CL) der Bitleitung durch einen ersten vorbestimmten Abstand getrennt ist;
Bestimmen einer zweiten Position ($C_{BH}$), die in der Mitte der Bitleitung angeordnet ist und von der ersten Position durch einen zweiten vorbestimmten Abstand getrennt ist; und
Bestimmen einer Position der Wortleitung (WL), so daß die Wortleitung zwischen den ersten und zweiten Kontaktlöchern angeordnet ist, bei dem:

die erste Position einer Mitte ($C_{SH}$) des ersten Kontaktlochs (SH) entspricht; und
die zweite Position einer Mitte ($C_{BH}$) des zweiten Kontaktlochs (BH) entspricht.

24. Verfahren nach Anspruch 23, dadurch gekennzeichnet, daß:

der erste vorbestimmte Abstand nahezu gleich b/2 + c + e ist, wobei b eine Breite der Bitleitung ist, c die Hälfte einer Breite des ersten Kontaktlochs ist und e eine Ausrichtungstoleranz von jedem der ersten Kontaktlöcher ist;
der zweite vorbestimmte Abstand nahezu gleich a + c + d + 2e ist, wobei a die Hälfte einer Breite des zweiten Kontaktlochs ist.

25. Verfahren zum Anordnen von Strukturelementen eines dynamischen Speichers mit wahlfreiem Zugriff nach Anspruch 1 oder 12 mit den folgenden Schritten:

Bestimmen einer ersten Position ($C_{BH}$), die in einer Mitte (CL) der Bitleitung angeordnet ist;
Bestimmen einer zweiten Position ($C_{SH}$), die auf einer imaginären Linie angeordnet ist, die sich von der ersten Position aus in einem vorbestimmten Winkel (θ) bezüglich der Bitleitung erstreckt, und von der Mitte der Bitleitung durch einen vorbestimmten Abstand getrennt ist; und
Bestimmen einer Position der Wortleitung (WL), so daß die Wortleitung zwischen den ersten und zweiten Kontaktlöchern positioniert ist, bei dem:
die erste Position einer Mitte ($C_{BH}$) des zweiten Kontaktlochs (BH) entspricht; und
die zweite Position einer Mitte ($C_{SH}$) des ersten Kontaktlochs (SH) entspricht.

26. Verfahren nach Anspruch 25, dadurch gekennzeichnet, daß:

der vorbestimmte Winkel θ im wesentlichen wie folgt definiert ist:

$$\theta = \sin^{-1}[(1/2b + e + c) / (a + c + d + 2e)]$$

wobei

a: die Hälfte einer Breite des zweiten Kontaktlochs ist,
e: eine Ausrichtungstoleranz von jedem der ersten und zweiten Kontaktlöcher ist,
d: eine Breite der Wortleitung ist,
c: die Hälfte einer Breite des zweiten Kontaktlochs ist und
b: eine Breite der Bitleitung ist; und

der vorbestimmte Abstand nahezu gleich b/2 + c + e ist.

## Revendications

1. Mémoire vive dynamique comprenant :

un substrat semiconducteur (1) comportant une région active (AR) incluant des première et seconde régions de diffusion (D, S) d'un transistor de transfert ;
une couche d'isolation (2, 3) formée sur ledit substrat semiconducteur et comportant des premier et second trous de contact (SH, BH) ;
un condensateur empilé (SC) comportant une électrode de stockage (SE) qui est connectée électriquement à ladite première région de diffusion par l'intermédiaire dudit premier trou de contact formé dans ladite couche d'isolation et une électrode opposée (CP) ;
une ligne de mot (WL) isolée électriquement dudit substrat semiconducteur ; et
une ligne de bit (BL) isolée électriquement dudit substrat semiconducteur et connectée électriquement à ladite seconde région de diffusion par l'intermédiaire dudit second trou de contact formé dans ladite couche d'isolation ;
une couche conductrice formant les lignes de bit (BL) est située à un niveau inférieur à celui d'une couche conductrice qui forme l'électrode opposée (CP),

ledit second trou de contact étant placé au niveau d'un centre de ladite ligne de bit,

ladite région active (AR) étant agencée à l'oblique par rapport à ladite ligne de bit (BL) et à ladite ligne de mot (WL), de telle sorte que le premier trou de contact (SH) ne chevauche pas la ligne de bit (BL), et la seconde région de diffusion étant disposée de manière à croiser la ligne de bit,

caractérisée en ce que lesdits trous de contact présentent une forme approximativement circulaire, ladite ligne de mot comporte une partie incurvée (Z, Z', Z1, Z2, Z3) située entre lesdits premier (SH) et second (BH) trous de contact, ladite partie incurvée étant sensiblement concentrique au centre dudit second trou de contact (BH) et comprenant une pluralité de segments rectilignes séparés dudit second trou de contact (BH) par une distance qui est égale ou supérieure à une distance minimum prédéterminée, et en ce que la région active (AR) comprend une partie active incurvée (AR') qui est incurvée au niveau du centre dudit premier trou de contact (SH) et qui s'étend vers ladite ligne de bit (BL).

2. Mémoire vive dynamique selon la revendication 1, caractérisée en ce que ladite partie incurvée (Z, Z') de la ligne de mot est agencée de manière à ce que ladite partie incurvée soit orthogonale à une ligne imaginaire qui relie un centre ($C_{SH}$) dudit premier trou de contact (SH) et un centre ($C_{BH}$) dudit second trou de contact (BH).

3. Mémoire vive dynamique selon la revendication 1, dans laquelle ladite région active (AR) est agencée le long d'une ligne imaginaire qui relie un centre ($C_{SH}$) dudit premier trou de contact (SH) et un centre ($C_{BH}$) dudit second trou de contact (BH).

4. Mémoire vive dynamique selon l'une quelconque des revendications 1 à 3, caractérisée en ce que ladite partie incurvée (Z') de la ligne de mot présente un motif en arc de cercle.

5. Mémoire vive dynamique selon l'une quelconque des revendications 1 à 3, caractérisée en ce que :

ladite partie incurvée (Z) de la ligne de mot comporte une première zone (Z1), une seconde zone (Z2) et une troisième zone (Z3) qui sont formées d'un seul tenant dans cet ordre ;

ladite seconde zone est orthogonale à ladite ligne de bit ; et

l'une desdites première et seconde zones est orthogonale à une ligne imaginaire qui relie un centre ($C_{SH}$) dudit premier trou de contact (SH) et un centre ($C_{BH}$) dudit second trou de contact (BH).

6. Mémoire vive dynamique selon la revendication 5, caractérisée en ce que lesdites première et troisième zones (Z1, Z3) sont agencées de façon symétrique l'une par rapport à l'autre par rapport à ladite seconde zone.

7. Mémoire vive dynamique selon la revendication 1, caractérisée en ce que :

ladite région active (AR) comprend une partie droite formée d'un seul tenant avec sa dite partie active incurvée (AR') ; et

ladite partie active incurvée de la région active est partiellement symétrique à ladite partie droite par rapport audit centre ($C_{SH}$) du premier trou de contact (SH).

8. Mémoire vive dynamique selon la revendication 1, caractérisée en ce que ladite partie active incurvée (AR') de la région active (AR) présente une extrémité qui est située au-dessous de ladite ligne de bit (BL).

9. Mémoire vive dynamique selon la revendication 1, caractérisée en ce que ladite partie active incurvée (AR') de la région active (AR) est agencée à l'oblique par rapport à ladite ligne de bit (BL).

10. Mémoire vive dynamique selon l'une quelconque des revendications 1 à 9, caractérisée en ce que :

une ligne imaginaire qui relie un centre ($C_{SH}$) dudit premier trou de contact (SH) et un centre ($C_{BH}$) dudit second trou de contact (BH) est inclinée selon un angle $\theta$ par rapport à une direction selon laquelle ladite ligne de bit (BL) s'étend ; et

ledit angle $\theta$ est sensiblement défini de la manière suivante :

$$\theta = \sin^{-1}[(1/2b + e + c) / (a + c + d + 2e)]$$

où

a : une demi-largeur du second trou de contact,

e : une marge d'alignement de chacun desdits premier et second trous de contact,

d : une largeur de la ligne de mot,

c : une demi-largeur dudit second trou de contact, et

b : une largeur de ladite ligne de bit.

11. Mémoire vive dynamique selon l'une quelconque des revendications 1 à 10, caractérisée en ce que ladite première région de diffusion est une région de drain (D) et en ce que ladite seconde région de diffusion est une région de source (S).

12. Mémoire vive dynamique selon la revendication 1, comprenant, sur ledit substrat semiconducteur (1) :

une pluralité desdites régions actives (AR), chacune d'entre elles incluant des première et seconde régions de diffusion (D, S) d'un transistor de transfert respectif ;

ladite couche d'isolation (2, 3) comportant une pluralité de premiers trous de contact (SH) et une pluralité de seconds trous de contact (BH) ;

une pluralité desdits condensateurs empilés (SC), chacun d'entre eux comportant une électrode de stockage (SE) qui est connectée électriquement à l'une correspondante desdites premières régions de diffusion par l'intermédiaire de l'un correspondant desdits premiers trous de contact formés dans ladite couche d'isolation, et une électrode opposée (CP),

une pluralité desdites lignes de mot (WL) isolées électriquement dudit substrat semiconducteur ; et

une pluralité desdites lignes de bit (BL) isolées électriquement dudit substrat semiconducteur, chacune desdites lignes de bit étant connectée électriquement à l'une correspondante desdites secondes régions de diffusion par l'intermédiaire de l'un correspondant des seconds trous de contact formés dans ladite couche d'isolation ;

chacun desdits seconds trous de contact étant positionné au niveau d'un centre (CL) desdites lignes de bit,

chacune desdites régions actives (AR) étant agencée à l'oblique par rapport auxdites lignes de bit (BL) et auxdites lignes de mot (WL), la seconde région de diffusion étant placée de manière à croiser la ligne de bit,

dans laquelle chacune desdites lignes de mot comporte une pluralité desdites parties incurvées (Z, Z') situées entre des premiers et seconds trous de contact correspondants, chaque partie incurvée étant séparée de l'un correspondant desdits seconds trous de contact par ladite distance prédéterminée, et

chacune desdites régions actives (AR) comprend une partie active incurvée (AR') qui est incurvée au niveau d'un centre de l'un correspondant des premiers trous de contact (SH) et qui s'étend vers l'une correspondante des lignes de bit (BL).

13. Mémoire vive dynamique selon la revendication 12, caractérisée en ce que:

chacun desdits premiers trous de contact (SH) est situé presque à égale distance de deux lignes de mot adjacentes prises parmi ladite pluralité de lignes de mot (WL) ; et

chacun desdits premiers trous de contact est situé presque à égale distance de deux lignes de bit adjacentes prises parmi ladite pluralité de lignes de bit (BL).

14. Mémoire vive dynamique selon la revendication 12 ou 13, caractérisée en ce que chaque partie incurvée (Z, Z') de chacune des lignes de mot (WL) est agencée de manière à ce que chaque partie incurvée soit orthogonale à une ligne imaginaire qui relie un centre ($C_{SH}$) dudit un correspondant des premiers trous de contact (SH) et un centre ($C_{BH}$) dudit un correspondant des seconds trous de contact (BH).

15. Mémoire vive dynamique selon la revendication 12, caractérisée en ce que chacune desdites régions actives (AR) est agencée selon une ligne imaginaire qui relie un centre ($C_{SH}$) de l'un correspondant desdits premiers trous de contact (SH) et un centre ($C_{BH}$) de l'un correspondant desdits seconds trous de contact (BH).

16. Mémoire vive dynamique selon l'une quelconque des revendications 12 à 15, caractérisée en ce que chaque partie incurvée de chacune des lignes de mot (WL) présente un motif en arc de cercle (Z').

17. Mémoire vive dynamique selon l'une quelconque des revendications 12 à 15, caractérisée en ce que chacune desdites régions actives (AR) comprend une partie active incurvée (AR') s'étendant vers l'une correspondante des lignes de bit (BL).

18. Mémoire vive dynamique selon la revendication 17, caractérisée en ce que :

chacune desdites régions actives (AR) comprend une partie droite formée d'un seul tenant avec sa dite partie active incurvée (AR') ; et

ladite partie active incurvée de chacune des régions actives est partiellement symétrique à ladite partie droite par rapport audit centre ($C_{SH}$) dudit un correspondant des premiers trous de contact (SH).

19. Mémoire vive dynamique selon la revendication 17, caractérisée en ce que ladite partie active incurvée (AR') de chacune desdites régions actives (AR) comporte une extrémité qui est située au-dessous de l'une correspondante des lignes de bit (BL).

20. Mémoire vive dynamique selon la revendication 17, caractérisée en ce que ladite partie active incurvée (AR') de chacune desdites régions actives (AR) est agencée à l'oblique par rapport à l'une correspondante des lignes de bit (BL).

21. Mémoire vive dynamique selon l'une quelconque des revendications 12 à 20, caractérisée en ce que :

une ligne imaginaire qui relie le centre de l'un desdits premiers trous de contact (SH) et un centre de l'un correspondant desdits seconds trous de contact (BH) est inclinée selon un angle θ par rapport à une direction selon laquelle lesdites lignes de bit (BL) s'étendent ; et
ledit angle θ est défini de la manière suivante :

$$\theta = \sin^{-1} [(1/2b + e + c) / (a + c + d + 2e)]$$

où

a : une demi-largeur de chacun des seconds trous de contact,
e : une marge d'alignement de chacun desdits premiers et seconds trous de contact,
d : une largeur de chacune des lignes de mot, une demi-largeur de chacun desdits seconds trous de contact, et
b : une largeur desdites lignes de bit.

22. Mémoire vive dynamique selon l'une quelconque des revendications 12 à 21, dans laquelle lesdites lignes de bit sont du type ligne de bit repliée.

23. Procédé d'agencement d'éléments structurels d'une mémoire vive dynamique selon la revendication 1 ou 12, comprenant les étapes de :

détermination d'une première position ($C_{SH}$) qui est séparée d'un centre (CL) de ladite ligne de bit d'une première distance prédéterminée ;
détermination d'une seconde position ($C_{BH}$) qui est située au niveau du centre de ladite ligne de bit et qui est séparée de ladite première position d'une seconde distance prédéterminée ; et
détermination d'une position de ladite ligne de mot (WL) de manière à ce que ladite ligne de mot soit située entre lesdits premier et second trous de contact, dans laquelle :

ladite première position correspond à un centre ($C_{SH}$) dudit premier trou de contact (SH) ; et
ladite seconde position correspond à un centre ($C_{BH}$) dudit second trou de contact (BH).

24. Procédé selon la revendication 23, caractérisé en ce que :

ladite première distance prédéterminée est approximativement égale à b/2 + c + e où b est une largeur de ladite ligne de bit, c est une demi-largeur dudit premier trou de contact et e est une marge d'alignement de chacun desdits premiers trous de contact ;
ladite seconde distance prédéterminée est approximativement égale à a + c + d + 2e où a est une demi-largeur dudit second trou de contact.

25. Procédé d'agencement d'éléments structurels d'une mémoire vive dynamique selon la revendication 1 ou 12, comprenant les étapes de :

détermination d'une première position ($C_{BH}$) qui est située au niveau d'un centre (CL) de ladite ligne de bit ;
détermination d'une seconde position ($C_{SH}$) qui est située sur une ligne imaginaire s'étendant depuis ladite première position selon un angle prédéterminé (θ) par rapport à ladite ligne de bit et qui est séparée du centre de ladite ligne de bit d'une distance prédéterminée ; et
détermination d'une position de ladite ligne de mot (WL) de manière à ce que ladite ligne de mot soit située entre lesdits premier et second trous de contact, dans laquelle :

ladite première position correspond à un centre ($C_{BH}$) dudit second trou de contact (BH) ; et
ladite seconde position correspond à un centre ($C_{SH}$) dudit premier trou de contact (SH).

26. Procédé selon la revendication 25, caractérisé en ce que :

ledit angle θ prédéterminé est sensiblement défini de la manière suivante

$$\theta = \sin^{-1} [(1/2b + e + c) / (a + c + d + 2e)]$$

où

a : une demi-largeur dudit second trou de contact,
e : une marge d'alignement de chacun desdits premier et second trous de contact,
d : une largeur de ladite ligne de mot,
c : une demi-largeur dudit second trous de contact, et
b : une largeur de ladite ligne de bit ; et

ladite distance prédéterminée est approximativement égale à b/2 + c + e.

FIG. I PRIOR ART

# FIG.2 PRIOR ART

# FIG.3

$C_{SH}$

$TA$

$C_{BH}$

$CL$

$\theta$

$a + c + d + 2e$

$BL$

$\dfrac{b}{2} + c + e$

$TA$

$C_{SH}$

# FIG.5A

$Si_3N_4$

# FIG.5B

$OY$

$OX$

$Si_3N_4$

# FIG. 4

EP 0 684 649 B1

FIG.6

# FIG. 7A

FIG.7B

FIG.7C

# FIG. 8

EP 0 684 649 B1